# NEW EUROPEAN PATENT SPECIFICATION

(11) **EP 0 619 609 B2**
(45) Date of publication and mention of the opposition decision: **05.06.2002**
(45) Mention of the grant of the patent: 18.02.1998
(21) Application number: 94400752.5
(22) Date of filing: 06.04.1994
(51) Int. Cl.: H01L 27/02

(54) **Electrostatic discharge protection device for MOS integrated circuits**
Elektrostatische Entladungsschutzvorrichtung für integrierte MOS-Schaltungen
Dispositif de protection contre les décharges électrostatiques pour circuits intégrés

(30) Priority: 09.04.1993 FR 9304263
(43) Date of publication of application: 12.10.1994
(73) Proprietor: ATMEL NANTES SA, 44300 Nantes (FR)
(72) Inventor: Crevel, Philippe, F-44640 Saint Jean de Boiseau (FR); Quero, Alain, F-44000 Nantes (FR)
(74) Representative: Loisel, Bertrand

(56) References cited:
- EP-A- 0 568 341
- US-A- 4 694 315
- US-A- 4 896 243
- US-A- 5 077 591
- JOURNAL OF ELECTROSTATICS vol. 29, no. 1 , December 1992 , AMSTERDAM NL pages 1 - 19 C. DUVVURY ET R. ROUNTREE 'A synthesis of ESD input protection scheme'
- IEEE Electron Devices Letters Vol.12. 1991 p21-22
- Rudolf Müller: Bauelemente der Halbleiter Elektronik, 1987, Springer Verlag, 3. Auflage, Seite 19

## Description

The present invention relates to the protection of the inputs of integrated circuits against electrostatic discharges (ESD) which may appear when they are handled. The integrated circuits to be protected are MOS circuits, i.e. including a substrate made of doped semiconductor on which MOS (metal-oxide-semiconductor) transistors are formed, some of the transistors having their gate control input linked to an input pad of the circuit. The invention applies especially to CMOS (complementary MOS)-type circuits.

When the circuit is handled, electrostatic charges may appear on the input pad and risk causing a discharge (typically a few thousand volts for a few nanoseconds) capable of destroying the gate oxide of the transistors.

The MOS transistor uses the effect of the electric field through a thin oxide to bring about a conversion into current of the voltage present on the gate. The growing integration of technology leads to this oxide thickness being reduced in order to obtain a better amplifying power for the transistor, to the detriment of its capacity to withstand high voltages. The inputs of CMOS integrated circuits generally consist of control gates of MOS transistors and exhibit both high impedance and great sensitivity to electrostatic discharges.

In orderto satisfy the laws of integration, thinner and thinner gate oxides are produced nowadays, in which the breakdown voltages from now on are less than 20 volts for the most advanced technology.

The first protection devices used the avalanche regime of diodes mounted in reverse mode between the input pads and the Vss and Vcc power supply terminals. As long as the avalanche voltage of these diodes remains lower than the breakdown voltage of the gate oxide of the MOS transistors, the energy of the electrostatic discharge was able to be dissipated in the diodes. Unfortunately, with technical evolution, the avalanche voltages of these diodes have not fallen as much as the breakdown voltages of the gate oxides of the transistors. One solution frequently adopted is then the addition, in series between the input pad and the gate of the transistor, of a resistor which will form a time constant with the capacitance of the MOS transistor.

The use of turned-off MOS transistors in parallel with the input also constitutes an interesting alternative. During the electrostatic discharge, the voltage rises on the drain, up to the avalanche regime of the junction. In the case of a N+ diffusion for the drain, the holes thus created by avalanche diffuse into the substrate. The emission of these holes causes a potential drop in the region of the source diffusion which then behaves like the emitter of a bipolar transistor which has become conducting. This effect corresponds to the conduction regime of the MOS transistor by "snap-back". The transistor becomes conducting and removes the energy. The advantage of this solution with transistors is that the removal of the energy can be done for voltages which are lower than in the case of diodes. However, when the avalanche current becomes too high, there is a risk of destroying the protection transistor.

It is known (see US-A-4896243 or the article "A synthesis of ESD input protection scheme" by C. Duwury et al, which appeared in Journal of Electronics, Vol.29, No.1, Dec. 1992, pp. 1-19) to provide a protection thyristor in parallel with the turned-off MOS transistor. However, according to these documents, the thyristor triggers only under the effect of the voltage rise to which it is subjected. The relatively high value of the threshold voltage to be reached in order to trigger the thyristor constitutes a limitation of this known device.

In "A Low-Voltage Triggering SCR for On-chip ESD Protection at Output and Input Pads" (IEEE Electron Device Letters, Vol. 12, 1991, pages 21-22), A Chatterjee et al describe the integration into the thyristor layout of a n-MOS-like structure, in order to provide a component called LVTSCR ("Low-Voltage Triggering Silicon Controlled Rectifier") which reduces the triggering voltage of the thyristor (SCR). The component may be used to protect the outputs or inputs of an CMOS integrated circuit.

An object of the invention is to enhance the known protection devices in order to allow more effective removal of the electrostatic discharges, while reducing the risks of damaging the device.

With this object, the invention proposes an electrostatic discharge protection device for an integrated circuit as defined in claim 1.

When the voltage on the input pad rises, the voltage across the thyristor rises at the same time as that across the MOS transistor. When this voltage becomes sufficient to create, by avalanche, electron-hole pairs within the junction of the MOS transistor, charge carriers migrate towards the region of the substrate which constitutes the control electrode of the thyristor. The latter then becomes conducting in order to remove the energy of the discharge. The triggering of the thyristor can be done for a relatively weak current of charge carriers, so that the risks of damage to the MOS transistor are substantially reduced. Furthermore, the removal of the energy of the discharge by a triggered thyristor is more effective than in the prior devices in which it results principally from an avalanche current.

Other features and advantages of the present invention will become apparent in the description below of a preferred but not limiting illustrative embodiment. In the attached drawings:
- Figure 1 is an electrical diagram of an integrated circuit incorporating a device according to the invention;
- Figures 2 and 3 are diagrammatic views, respectively in section and seen from above, of a device according to the invention; and
- Figure 4 is a chart showing a current-voltage characteristic of the device of Figures 2 and 3.

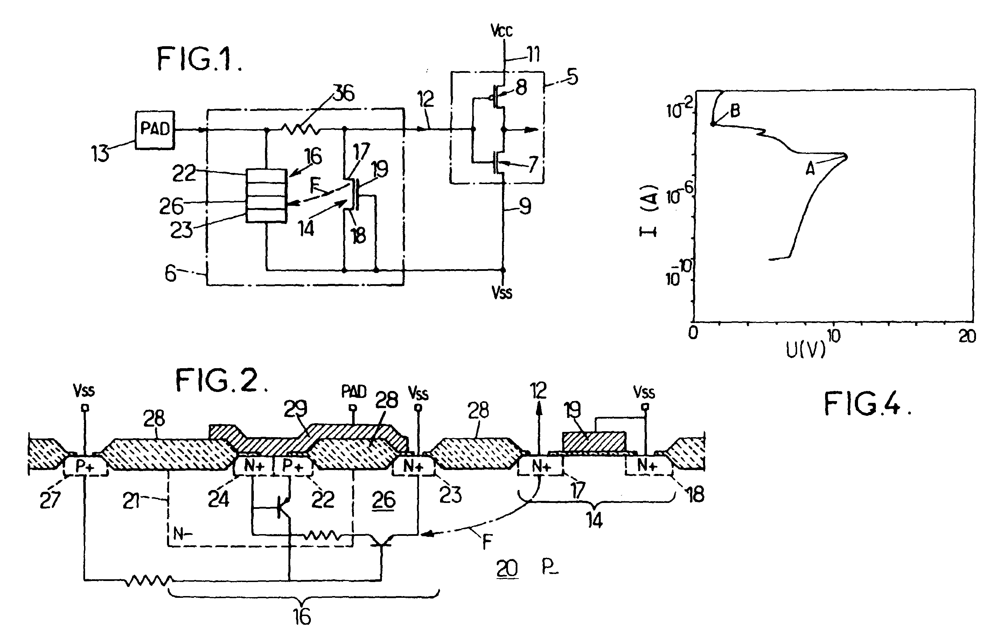

In Figure 1 an integrated circuit has been represented symbolically, produced on a common substrate (silicon) and including a CMOS circuit 5 and a protection device 6 according to the invention. The CMOS circuit 5 comprises MOS transistors 7, 8 supplied with power between a reference terminal 9 at a potential Vss and a reference terminal 11 at a potential Vcc. The terminal 9 is typically a ground terminal (Vss = 0 V) and the terminal 11 is a positive power supply terminal (Vcc = + 5 V). The MOS transistors 7, 8 have thin gate oxides (typically 20 nm) and some of them have their gate control input 12 linked to an input pad 13 by means of the protection device 6.

The protection device comprises a MOS transistor 14 connected between the gate control input 12 and the ground terminal 9, and a thyristor 16 connected between the input pad 13 and the ground terminal 9.

When the substrate 20 is of P- type, i.e. doped with impurities of the electron acceptor type (for example a substrate made of silicon with 10¹⁵ atoms of boron per cm³), the transistor 14 is of NMOS type (Figure 2). Its drain 17, connected to the gate control input 12, consists of a N+ type diffusion formed in the substrate 20, and its source 18, connected to the ground terminal 9, consists of another N+type diffusion formed in the substrate 20. These two diffusions correspond to a doping of the semiconductor with impurities of the electron donor type (for example silicon with 10²⁰ atoms of phosphorus per cm³). The gate 19 of the transistor 14, made of polycrystalline silicon, is also connected to the ground terminal 9, so that the NMOS transistor 14 is turned-off.

The thyristor 16 comprises a well 21 formed in the substrate and doped N- with impurities of electron donor type (for example silicon with 10¹⁶ atoms of phosphorus per cm³), in which the anode 22 of the thyristor is formed, which consists of a P+ type diffusion (for example silicon with 10²⁰ atoms of boron per cm³). Anode 22 is connected to the input pad 13. The cathode 23 of the thyristor 16, connected to the ground terminal 9, consists of a N+ type diffusion formed in the substrate 20 between the well 21 and the drain 17 of the NMOS transistor 14. Another N+ type diffusion 24 is formed in the well 21 beside the anode 22 and connected to the pad 13 in order to bias the well of the thyristor.

The control electrode 26 of the thyristor 16 consists of the region of the substrate 20 situated between the well 21 and the cathode 23 of the thyristor.

The substrate 20 is held at the potential Vss by a connection 27 consisting of a P+ type diffusion formed in the substrate 20. The well 21 of the thyristor is situated between this diffusion 27 and the NMOS transistor 14.

In Figure 2 the resistors and the bipolar transistors have been represented symbolically, forming the equivalent diagram of the thyristor 16. The semiconductor material of the protection device is covered by a thick oxide layer 28 leaving exposed the regions which have to be connected to other parts of the circuit. In order to connect the diffusions 22 and 24 of the thyristor to the input pad 13, a metallization 29 is used which, above the oxide 28, substantially covers the whole region situated between the anode 22 and the cathode 23 of the thyristor. This metallization 29 is in contact with the diffusions 22, 24 and connected to the input pad 13.

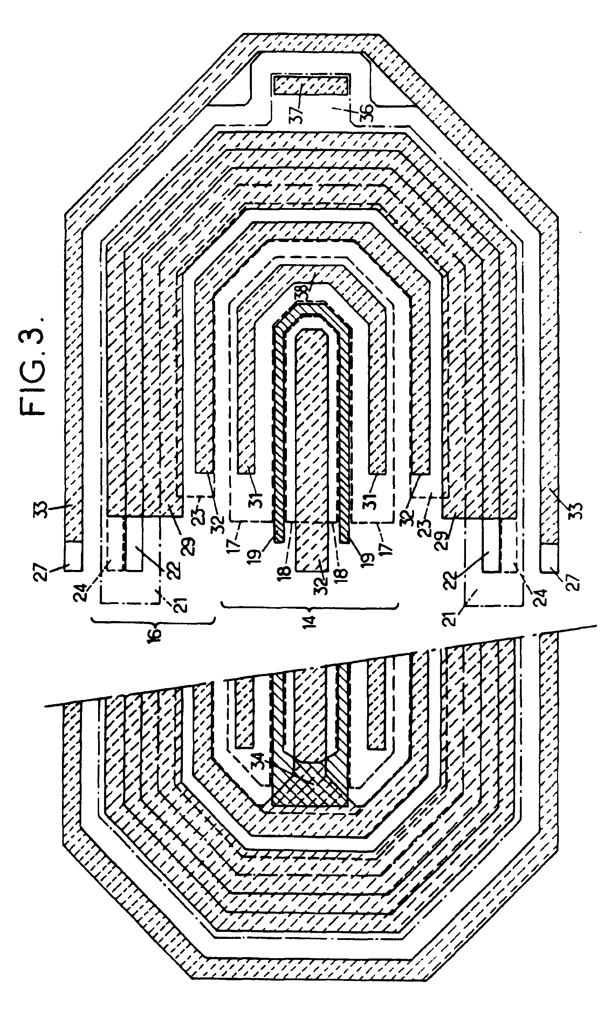

A diagrammatic top view of the protection device is represented in Figure 3. It is seen that the device, particularly the NMOS transistor 14 and the thyristor 16, has a general ring configuration on the substrate, the central part of which is not represented in order to facilitate the reading of the drawing. The N+ type diffusions 17, 18, 23, 24 are represented by contours in dashes. The P+ type diffusions 22, 27 are represented by contours in solid lines. The N- type well 21 is represented by a contour in dots and dashes. The polycrystalline silicon gate 19 of the NMOS transistor is represented by a hatched area. Finally the metallization 29, as well as the metallizations 31, 32 and 33 forming contacts respectively for the diffusions 17 (drain of the transistor 14), 18 (source of the transistor 14) and 27 (connection for the substrate 20), are represented by regions with broken hatching. The NMOS transistor 14 occupies the central part of the ring configuration. The diffusion 17 forming the drain of this transistor and its metallization 31 are interrupted on one side of the ring to allow a common connection to the ground terminal 9 of the gate 19 and source 18 of the transistor 14, and of the cathode 23 of the thyristor 16, in a region marked with the number 34.

On the opposite side of the ring, the well 21 is extended by a protrusion 36 which extends out to a contact area 37. In a way which is not represented, this contact area 37 is connected to the gate control input 12 and to another contact area 38 forming part of the metallization 31 relating to the drain of the NMOS transistor 14. The protrusion 36 of the well 21 forms a resistor of the order of 1 kΩ linking the gate control input 12 to the input pad 13 which is connected directly to the N- well 21 by the N+ diffusion 24 (see Figure 1).

When electrostatic charges appear on the input pad 13, a rise in voltage occurs between the substrate 20, at the potential Vss, and the drain 17 of the NMOS transistor 14. From a certain voltage threshold, electron-hole pairs are created by avalanche within the PN junction between the drain and the substrate. This results in a current of holes which diffuse into the substrate. Due to the resistivity of the substrate and to the fact that the connection 27 is further from the drain 17 than the region 26 forming the trigger electrode of the thyristor 16, the holes arrive in this region 26 before being removed by the connection 27 (arrow F in Figures 1 and 2). This local de-biasing of the substrate in the region 26 causes triggering of the thyristor 16 which becomes conducting with a very low resistivity so as to remove the energy of the discharge. The removal of the energy is particularly effective when the ring configuration represented in Figure 3 is adopted. The fact that the metallization 29 covers the region situated between the well 21 and the cathode 23 of the thyristor further enhances the removal of the energy by the supplementary effect of the thick-oxide, field-effect transistor thus created between the N-well and the N+ cathode. The resistor 36 connected between the input pad and the gate control input serves to limit the increase in the voltage on the drain of the NMOS transistor before the firing of the thyristor.

The current-voltage characteristic of a protection device according to the invention is presented in Figure 4, in which the abscissae indicate the voltage U in volts between the input pad 13 and the ground terminal 9, and in which the ordinates indicate, in logarithmic coordinates, the current strength I in amps of a current injected into the input pad. This electrical plot was obtained by forcing a current ramp I, which makes it possible better to view the triggering of the thyristor and its hold point as indicated in Figure 4 respectively by the points A and B. This characteristic shows that the overvoltage appearing on the input pad does not exceed 11 volts and that a current of 100 mA can be withstood by the structure without degradation. Upon an electrostatic discharge, the same protection mechanism by short circuit is implemented.

The device according to the invention is particularly suitable for CMOS-type integrated circuits, as this technology already presupposes the formation of N- wells in a P- substrate in order to produce the complementary MOS transistors. Accordingly, the production of the thyristor 16 does not need an additional process step for producing the well 21. Needless to say, if the circuit includes several input pads, a protection device will be provided for each input pad.

## Claims

1. Electrostatic discharge protection device for an integrated circuit, the integrated circuit including a substrate (20) made of semiconductor doped with impurities of a first type and on which at least one MOS transistor (7, 8) is formed, having its gate control input (12) electrically connected to an input pad (13) of the integrated circuit, the protection device (6) comprising :
- a turned-off MOS transistor (14) having a drain (17) consisting of a diffusion of a second type of impurities formed in the substrate (20) doped with the first type of impurities and electrically connected to the gate control input (12), a source (18) consisting of a diffusion of the second type of impurities formed in the substrate (20) and electrically connected to a reference terminal (9) of the integrated circuit, and a gate (19) electrically connected to the reference terminal (9), and
- a thyristor (16) having a well (21) formed in the substrate (20) and doped with the second type of impurities, a first electrode (22) consisting of a diffusion of the first type of impurities formed in the well (21) and electrically connected to the input pad (13), a second electrode (23) consisting of a diffusion of the second type of impurities formed in the substrate (20) between the well (21) and the drain (17) of the turned-off MOS transistor and electrically connected to the reference terminal (9) and a control electrode (26) consisting of a region of the substrate (20) so situated as to receive, by diffusion in the substrate, a current of charge carriers produced by avalanche within the junction between the substrate (20) and the drain (17) of the turned-off MOS transistor (14), whereby the thyristor is triggered when a voltage rise occurs on said junction.

2. Device according to Claim 1, **characterized in that** a diffusion (24) of the second type of impurities is formed in the well (21) of the thyristor and electrically connected to the input pad (13).

3. Device according to Claim 1 or 2, **characterized in that** a diffusion (27) of the first type of impurities is formed in the substrate (20) and electrically connected to the reference terminal (9), the well (21) of the thyristor being situated between this diffusion (27) of the first type of impurities and the turned-off MOS transistor (14).

4. Device according to any one of Claims 1 to 3, **characterized by** a metallization (29) connected to the input pad (13), this metallization being in contact with the first electrode (22) of the thyristor (16) and substantially covering the whole region situated between the first and second electrodes (22, 23) of the thyristor.

5. Device according to any one of Claims 1 to 4, **characterized by** a resistor (36) electrically connected between the input pad (13) and the gate control input (12).

6. Device according to Claim 5, **characterized in that** the said resistor (36) consists of a region of the well (21) of the thyristor.

7. Device according to any one of Claims 1 to 6, **characterized in that** the turned-off MOS transistor (14) and the thyristor (16) have a general ring configuration on the substrate (20).

8. Device according to Claim 7, **characterized in that** the turned-off MOS transistor (14) occupies the central part of the ring configuration.

## Patentansprüche

1. Elektrostatische Entladeschutzvorrichtung für eine integrierte Schaltung, wobei die integrierte Schaltung ein Substrat (20) aufweist, das aus einem Halbleiter besteht, der mit Unreinheiten eines ersten Typs dotiert ist und auf dem mindestens ein MOS-Transistor (7, 8) ausgebildet ist, dessen Gate-Steuereingang (12) elektrisch verbunden mit einer Eingangseinheit (13) ist, wobei die Schutzvorrichtung (6) umfaßt:
- einen gesperrten MOS-Transistor (14) mit einem Drain (17), der aus einer Diffusion eines zweiten Typs von Unreinheiten besteht, die in dem mit dem ersten Typ von Unreinheiten dotierten Substrat (20) gebildet sind, und elektrisch mit dem Gate-Steuereingang (12) verbunden ist, mit einer Source (18), die aus einer Diffusion des zweiten Typs von im Substrat (20) gebildeten Unreinheiten besteht und elektrisch mit einem Referenzanschluß (9) der integrierten Schaltung verbunden ist, und mit einem Gate (19), das mit dem Referenzanschluß (9) verbunden ist, und
- einem Thyristor (16) mit einer Potentialmulde (21), die im Substrat (20) ausgebildet ist und mit Unreinheiten des zweiten Typs dotiert ist, mit einer ersten Elektrode (22), die aus einer Diffusion von Unreinheiten des ersten Typs, die in der Potentialmulde (21) gebildet sind, besteht und elektrisch mit der Eingangseinheit (13) verbunden ist, mit einer zweiten Elektrode (23), die aus einer Diffusion von Unreinheiten des zweiten Typs, die in dem Substrat (20) zwischen der Potentialmulde (21) und dem Drain (17) des gesperrten MOS-Transistor gebildet sind, besteht und elektrisch mit dem Referenzanschluß (9) und einer Steuerelektrode (26) verbunden ist, die aus einem Bereich des Substrates (20) besteht, der so angeordnet ist, daß er durch Diffusion in dem Substrat einen Strom von Ladungsträgern empfängt, der durch eine Lawine innerhalb der Grenzschicht zwischen dem Substrat (20) und dem Drain (17) des gesperrten MOS-Transistors (14) produziert wird, wodurch der Thyristor getriggert wird, wenn ein Spannungsanstieg in der Grenzschicht auftritt.

2. Vorrichtung gemäß Anspruch 1, **dadurch gekennzeichnet, daß** eine Diffusion (24) von Unreinheiten des zweiten Typs in der Potentialmulde (21) des Thyristors gebildet ist und elektrisch mit der Eingangseinheit (13) verbunden ist.

3. Vorrichtung gemäß Anspruch 1 oder 2, **dadurch gekennzeichnet, daß** eine Diffusion (27) von Unreinheiten des ersten Typs in dem Substrat (20) gebildet ist und elektrisch mit dem Referenzanschluß (9) verbunden ist, wobei die Potentialmulde (21) des Thyristors zwischen dieser Diffusion (27) der Unreinheiten des ersten Typs und dem abgeschalteten MOS-Transistors (14) angeordnet ist.

4. Vorrichtung gemäß einem der Ansprüche 1 bis 3, **gekennzeichnet durch** eine Metallisierung (29), die mit der Eingangseinheit (13) verbunden ist, wobei die Metallisierung in Kontakt mit der ersten Elektrode (22) des Thyristors (16) steht und im wesentlichen die gesamte Zone bedeckt, die zwischen den ersten und zweiten Elektroden (22, 23) des Thyristors angeordnet ist.

5. Vorrichtung gemäß einem der Ansprüche 1 bis 4, **gekennzeichnet durch** einen Widerstand (36), der elektrisch zwischen die Eingangseinheit (13) und den Gate-Steuereingang (12) geschaltet ist.

6. Vorrichtung gemäß Anspruch 5, **dadurch gekennzeichnet, daß** der Widerstand (36) aus einer Zone der Potentialmulde (21) des Thyristors besteht.

7. Vorrichtung gemäß einem der Ansprüche 1 bis 6, **dadurch gekennzeichnet, daß** der gesperrte MOS-Transistor (14) und der Thyristor (16) eine allgemeine Ringkonfiguration auf dem Substrat (20) aufweisen.

8. Vorrichtung gemäß Anspruch 7, **dadurch gekennzeichnet, daß** der ab gesperrte MOS-Transistor (14) den zentralen Teil der Ringkonfiguration besetzt.

## Revendications

1. Dispositif de protection contre les décharges électrostatiques pour un circuit intégré, le circuit intégré comportant un substrat (20) en semiconducteur dopé avec des impuretés d'un premier type et sur lequel est formé au moins un transistor MOS (7, 8) ayant son entrée de commande de grille (12) connectée électriquement à un plot d'entrée (13), le dispositif de protection (6) comprenant :
- un transistor MOS bloqué (14) ayant un drain (17) consistant en une diffusion d'un second type d'impuretés formée dans le substrat (20) dopé avec le premier type d'impuretés et connecté électriquement à l'entrée de commande de grille (12), une source (18) consistant en une diffusion du second type d'impuretés formée dans le substrat (20) et connectée électriquement à la borne de référence (9) du circuit intégré, et une grille (19) connectée électriquement à la borne de référence (9) du circuit intégré, et
- un thyristor (16) ayant un puits (21) formé dans le substrat (20) et dopé avec le second type d'impuretés, une première électrode (22) consistant en une diffusion du premier type d'impuretés formée dans le puits (21) et connectée électriquement au plot d'entrée (13), une seconde électrode (23) consistant en une diffusion du second type d'impuretés formée dans le substrat (20) entre le puits (21) et le drain (17) du transistor MOS bloqué et connectée électriquement à la borne de référence (9), et une électrode de commande (26) consistant en une zone du substrat (20) située pour recevoir, par diffusion dans le substrat, un courant de porteurs de charge produit par avalanche au niveau de la jonction entre le substrat (20) et le drain (17) du transistor MOS bloqué (14), de manière à déclencher le thyristor lorsqu'une élévation de tension se produit sur ladite jonction.

2. Dispositif selon la revendication 1, **caractérisé en ce qu'**une diffusion (24) du second type d'impuretés est formée dans le puits (21) du thyristor et connectée électriquement au plot d'entrée (13).

3. Dispositif selon la revendication 1 ou 2, **caractérisé en ce qu'**une diffusion (27) du premier type d'impuretés est formée dans le substrat (20) et connectée électriquement à la borne de référence (9), le puits (21) du thyristor étant situé entre cette diffusion (27) du premier type d'impuretés et le transistor MOS bloqué (14).

4. Dispositif selon l'une quelconque des revendications 1 à 3, **caractérisé par** une métallisation (29) connectée au plot d'entrée (13), cette métallisation étant en contact avec la première électrode (22) du thyristor (16) et recouvrant sensiblement toute la région située entre les première et seconde électrodes (22, 23) du thyristor.

5. Dispositif selon l'une quelconque des revendications 1 à 4, **caractérisé par** une résistance (36) connectée électriquement entre le plot d'entrée (13) et l'entrée de commande de grille (12).

6. Dispositif selon la revendication 5, **caractérisé en ce que** ladite résistance (36) est constituée par une zone du puits (21) du thyristor.

7. Dispositif selon l'une quelconque des revendications 1 à 6, **caractérisé en ce que** le transistor MOS bloqué (14) et le thyristor (16) ont un agencement général en anneau sur le substrat (20).

8. Dispositif selon la revendication 7, **caractérisé en ce que** le transistor MOS bloqué (14) occupe la partie centrale de l'agencement en anneau.
